# EUROPEAN PATENT APPLICATION

(11) **EP 4 636 809 A1**
(43) Date of publication of application: **22.10.2025**
(21) Application number: 24864360.3
(22) Date of filing: 13.08.2024
(51) Int. Cl.: H01L 21/18

(54) **SOLAR CELL AND METHOD FOR MANUFACTURING SOLAR CELL**

(30) Priority: 12.09.2023 CN 202311175882
(71) Applicant: Longi Green Energy Technology Co., Ltd., Xi'an, Shaanxi 710100 (CN)
(72) Inventor: TONG, Hongbo, Xi' an, Shaanxi 710100 (CN); YU, Long, Xi' an, Shaanxi 710100 (CN); CHEN, Shi, Xi' an, Shaanxi 710100 (CN); LI, Hua, Xi' an, Shaanxi 710100 (CN)
(74) Representative: Pfenning, Meinig & Partner mbB
(86) International application number: PCT/CN2024/111802
(87) International publication number: WO 2025/055637

(57) **Abstract**

The present application discloses a solar cell and a method for manufacturing a solar cell, and relates to the field of solar cell technologies, to resolve a problem that bus electrodes made of metal are completely in direct contact with a semiconductor substrate, resulting in high metal recombination on a surface of the solar cell and reduction of efficiency of the solar cell. The solar cell includes: a semiconductor substrate, first conductive contact layers, bus electrodes, and collector electrodes. The first conductive contact layers are formed on at least one surface of the semiconductor substrate, extend in a first direction, and are spaced apart in a second direction. The bus electrodes are formed over the first conductive contact layers, and disposed on at least one surface of the semiconductor substrate. The bus electrodes extend in the first direction and are spaced apart in the second direction. A projection of at least one of the first conductive contact layers on the semiconductor substrate overlaps with a projection of the bus electrodes on the semiconductor substrate, and the first direction is different from the second direction.

## Description

### CROSS-REFERENCE TO RELATED APPLICATIONS

The present application claims priority to Chinese Patent Application No. 202311175882.0 and No. 202410711099.X, filed with the China National Intellectual Property Administration on September 12, 2023 and entitled "SOLAR CELL AND METHOD FOR MANUFACTURING SOLAR CELL", which is incorporated herein by reference in its entirety.

### TECHNICAL FIELD

The present application relates to the field of solar cell technologies, and in particular, to a solar cell and a method for manufacturing a solar cell.

### BACKGROUND

A solar cell is a device that uses solar energy and directly converts light energy into electrical energy by using a photoelectric effect or a photochemical effect. The solar cell generally includes structures such as a semiconductor substrate, collector electrodes, and bus electrodes. The collector electrodes and the bus electrodes are generally made of metal.

In the related art, the bus electrodes made of metal are completely in direct contact with the semiconductor substrate, resulting in high metal recombination on a surface of the solar cell. Consequently, efficiency of the solar cell is reduced.

### SUMMARY

An objective of the present application is to provide a solar cell and a method for manufacturing a solar cell, to reduce or eliminate metal recombination on a surface of the solar cell, so as to increase efficiency of the solar cell.

To achieve the foregoing objective, according to a first aspect, the present application provides a solar cell. The solar cell includes: a semiconductor substrate, first conductive contact layers, bus electrodes, and collector electrodes. The semiconductor substrate has a first surface and a second surface opposite to each other. The first conductive contact layers are formed on at least one of the first surface or the second surface of the semiconductor substrate, extend in a first direction, and are spaced apart in a second direction. The bus electrodes are disposed on at least one of the first surface or the second surface of the semiconductor substrate. The bus electrodes are formed over the first conductive contact layers. The bus electrodes extend in the first direction and are spaced apart in the second direction. A projection of at least one of the first conductive contact layers on the semiconductor substrate overlaps with a projection of the bus electrodes on the semiconductor substrate, and the first direction is different from the second direction. A plurality of collector electrodes extend in the second direction and are spaced apart in the first direction. At least one of the bus electrodes intersects with the collector electrodes.

In the solar cell provided in the present application, because the projection of at least one of the first conductive contact layers on the semiconductor substrate overlaps with the projection of the bus electrodes on the semiconductor substrate, there is a case in which some of the bus electrodes are in direct contact with the semiconductor substrate or the bus electrodes are not in contact with the semiconductor substrate at all. Based on this, compared with the related art, metal recombination on a surface of the solar cell can be reduced or eliminated, and an open-circuit voltage of the solar cell can be increased, to increase efficiency of the solar cell.

In an implementation, the solar cell further includes second conductive contact layers. The second conductive contact layers extend in the second direction and are spaced apart in the first direction. A projection of the collector electrodes on the semiconductor substrate overlaps with a projection of the second conductive contact layers on the semiconductor substrate. At least one of the first conductive contact layers intersects with the second conductive contact layers.

When the foregoing technical solution is adopted, with reference to the foregoing descriptions, the solar cell includes the first conductive contact layer and the second conductive contact layer. In this way, both contact resistivity and series resistance can be reduced, and a current can be effectively collected, to increase the efficiency of the solar cell. In addition, a transport distance of carriers can be reduced, to reduce a recombination loss of the carriers during transport.

In an implementation, one or more first conductive contact layers are between two adjacent bus electrodes.

When the foregoing technical solution is adopted, a first conductive contact layer is also between two adjacent bus electrodes. In this case, the transport distance of the carriers can be further reduced, to further reduce the recombination loss of the carriers during transport. Specifically, the carriers are recombined by impurity defects during transport. Therefore, the transport distance is reduced, and the recombination loss of the carriers is reduced.

**In** an implementation, a width of the first conductive contact layer between two adjacent bus electrodes is greater than or equal to 10 µm and less than or equal to 150 µm, and the width of the first conductive contact layer is measured along the second direction.

When the foregoing technical solution is adopted, shading by the first conductive contact layers on the semiconductor substrate can be reduced, to reduce impact on light absorption of the semiconductor substrate, and increase the efficiency of the solar cell. In addition, the passivation effect on the solar cell can be improved. Further, a transport distance of a current can be reduced, to reduce a current loss.

In an implementation, a width of a first conductive contact layer whose projection overlaps with the projection of the bus electrodes on the semiconductor substrate is greater than or equal to 50 µm and less than or equal to 300 µm, and the width of the first conductive contact layer is measured along the second direction.

When the foregoing technical solution is adopted, impact of a material for manufacturing the bus electrodes on an area of the surface of the semiconductor substrate can be reduced, or impact of a material for manufacturing the bus electrodes on the surface of the semiconductor substrate can be avoided. Further, in addition to having a passivation surface function, the first conductive contact layer further needs to have a function of collecting a current collected by the collector electrodes. Because metal used in the solar cell in the present application is usually a metal paste, the used metal material is usually metal power with a specific particle size, when metal-semiconductor alloy is formed, vertical etching is prone to occur. Based on this, the first conductive contact layer needs to have a specific thickness, to prevent metal from burning through the first conductive contact layer and being in direct contact with the semiconductor substrate. Therefore, the first conductive contact layer whose projection overlaps with the projection of the bus electrodes on the semiconductor substrate needs to have a specific thickness, to achieve a barrier function, so as to suppress metal recombination. **In** addition, a main function of a first conductive contact layer other than the first conductive contact layers directly under the bus electrodes is to assist the second conductive contact layer in collecting a current, to reduce the transport distance of the carriers, so as to reduce the recombination loss. However, because parasite absorption of the first conductive contact layer is strong (that is, when light passes through the first conductive contact layer, most light energy is absorbed by the first conductive contact layer without generating a large quantity of photogenerated carriers at a PN junction, and ineffective absorption is significant, resulting in a current loss), a thick first conductive contact layer causes reduction of the current. Further, when the width of the first conductive contact layer is less than 50 µm, the first conductive contact layer is likely to be removed in a cleaning process. When the width of the first conductive contact layer is less than a width of the bus electrodes, the first conductive contact layer cannot effectively collect a current. When the first conductive contact layer is of an incomplete structure, the first conductive contact layer cannot assist in transport, and even affects surface passivation. Furthermore, if the width of the first conductive contact layer is excessively large, light is severely shaded, causing reduction of the current.

In an implementation, a length of a first conductive contact layer whose projection overlaps with the projection of the bus electrodes on the semiconductor substrate is less than a length of the semiconductor substrate and greater than a length of a bus electrode; and a width of a first conductive contact layer whose projection overlaps with the projection of the bus electrodes on the semiconductor substrate is greater than a width of a bus electrode.

When the foregoing technical solution is adopted, complete direct contact between the bus electrodes and the semiconductor substrate are reduced or avoided in terms of the length and the width, so that metal recombination on the surface of the solar cell can be reduced or eliminated, and an open-circuit voltage of the solar cell can be increased, to increase the efficiency of the solar cell.

In an implementation, a length of a first conductive contact layer between two adjacent bus electrodes is less than or equal to a length of a first conductive contact layer whose projection overlaps with the projection of the bus electrodes on the semiconductor substrate; and/or a width of a first conductive contact layer between two adjacent bus electrodes is less than or equal to a width of a first conductive contact layer whose projection overlaps with the projection of the bus electrodes on the semiconductor substrate; and/or a thickness of a first conductive contact layer between two adjacent bus electrodes is less than or equal to a thickness of a first conductive contact layer whose projection overlaps with the projection of the bus electrodes on the semiconductor substrate.

When the foregoing technical solution is adopted, for the entire solar cell, an entire current collection process is that the surface of the solar cell is irradiated, a large quantity of photogenerated carriers are generated at the PN junction inside the solar cell, the photogenerated carriers are transferred to P regions and N regions or dope regions under the action of a built-in electric field to be separated to the surface, and all carriers that do not undergo recombination and that are collected on the surface of the semiconductor substrate are collected in a first conductive contact region in which the surface is in metal contact with the dope region. Therefore, to better collect a current, the first conductive contact regions should cover the entire surface of the semiconductor substrate base as much as possible. Therefore, the length of the first conductive contact layer should be long. However, an upper portion of the first conductive contact layer is irradiated, and parasite absorption of the first conductive contact layer is strong, that is, ineffective absorption is significant. In consideration of the foregoing situation, because it is necessary to prevent metal from etching the semiconductor substrate downward toward the edge, the first conductive contact layers under the bus electrodes need to have a larger width and thickness. The length, width, and thickness of the first conductive contact layers between the bus electrodes should be less than a length, width, and thickness of first conductive contact layers in other regions.

Because the first conductive contact layer between two adjacent bus electrodes has a current transfer function, there is no need to prevent complete direct contact between the bus electrodes and the semiconductor substrate. Therefore, the length, the width, and the thickness of the first conductive contact layer between two adjacent bus electrodes may be smaller than that of the first conductive contact layer whose projection overlaps with the projection of the bus electrodes on the semiconductor substrate, to save manufacturing materials and reduce costs.

In an implementation, a thickness of a first conductive contact layer whose projection overlaps with the projection of the bus electrodes on the semiconductor substrate is greater than or equal to 30 nm and less than or equal to 600 nm, and the thickness of the first conductive contact layer is measured along a direction from a first surface to a second surface of the semiconductor substrate.

When the foregoing technical solution is adopted, the thickness of the first conductive contact layer is greater than or equal to 30 nm, so that a probability that the material for manufacturing the bus electrodes burns through the semiconductor substrate can be reduced or eliminated, to reduce or eliminate the metal recombination on the surface of the solar cell, so as to increase the efficiency of the solar cell. Further, because parasite absorption of the first conductive contact layer is strong (that is, when light passes through the first conductive contact layer, most light energy is absorbed by the first conductive contact layer without generating a large quantity of photogenerated carriers, and ineffective absorption is significant, resulting in a current loss), a thick first conductive contact layer causes reduction of the current. Therefore, the thickness of the first conductive contact layer needs to be less than or equal to 600 nm.

In an implementation, the at least one first conductive contact layer whose projection overlaps with the projection of the bus electrodes on the semiconductor substrate has a first area, and a ratio of the first area to a sum of an area of the first conductive contact layers and an area of the second conductive contact layers is greater than or equal to 0.1% and less than or equal to 5%.

When the foregoing technical solution is adopted, theoretically, it is an optimal solution in which the bus electrodes completely cover the first conductive contact layer whose projection overlaps with the projection of the bus electrodes on the semiconductor substrate. However, in an actual manufacturing process, except for a few metal processes that are high-cost and are not completely mature, such as galvanization and evaporation, it is impossible to achieve complete coverage in a conventional metallization solution. Therefore, in an existing overprinting situation, obtained solar cell efficiency is optimal within the foregoing range.

In an implementation, the at least one first conductive contact layer whose projection overlaps with the projection of the bus electrodes on the semiconductor substrate has a first area, first conductive contact layers that are each between two adjacent bus electrodes has a second area, and a ratio of the second area to the first area is greater than or equal to 5% and less than or equal to 20%.

When the foregoing technical solution is adopted, the passivation effect, parasite absorption, current collection, and contact between metal and the semiconductor substrate are all considered. Within the foregoing range, the passivation effect is optimal, the parasite absorption is small, more currents are collected, the contact between metal and the semiconductor substrate is good, and metal recombination is reduced, so that the optimal cell efficiency is obtained.

In an implementation, a ratio of a sum of areas of first conductive contact layers and second conductive contact layers that are formed on the first surface of the semiconductor substrate to an area of the first surface of the semiconductor substrate is greater than or equal to 5% and less than or equal to 15%; and/or a ratio of a sum of areas of first conductive contact layers and second conductive contact layers that are formed on the second surface of the semiconductor substrate to an area of the second surface of the semiconductor substrate is greater than or equal to 5% and less than or equal to 15%.

When the foregoing technical solution is adopted, an area covered by conductive contact layers cannot be excessively large for the entire solar cell, and an excessively large area covered by the conductive contact layers reduces light absorption of the entire solar cell, and reduces generation of photogenerated carriers. In addition, photogenerated carriers generated on the entire solar cell also need to be collected. Considering efficiency of collecting the photogenerated carriers, the conductive contact layers should cover the entire surface as much as possible. However, considering disadvantages brought by shading of the conductive contact layers, the entire surface cannot be completely covered. In comprehensive consideration of the foregoing aspects, the first conductive contact layers and the second conductive contact layers are connected into a mesh. This not only avoids excessive shading, but also ensures current collection. In addition, good passivation effects of the first conductive contact layer and the second conductive contact layer can improve the passivation effect of the entire solar cell. However, an excessively small area covered by the conductive contact layers may cause a current collection path to be prolonged, and cause the series resistance to be increased, resulting in an increase in a recombination loss. A higher doping concentration of the first conductive contact layers and the second conductive contact layers is beneficial to forming good contact between metal and the semiconductor substrate, and a lower doping concentration is beneficial to reduction of recombination. Therefore, an area proportion and the doping concentration need to be comprehensively considered, so that the open-circuit voltage, a short-circuit current, and a fill factor of the solar cell are all considered, to form a solar cell structure with high solar cell efficiency.

According to a second aspect, the present application further provides a method for manufacturing a solar cell.

The method for manufacturing a solar cell includes:
providing a semiconductor substrate, where the semiconductor substrate has a first surface and a second surface opposite to each other;
forming, on at least one of the first surface or the second surface of the semiconductor substrate, first conductive contact layers extending in a first direction and spaced apart in a second direction;
forming, on the first conductive contact layers, bus electrodes extending in the first direction and spaced apart in the second direction, where a projection of at least one of the first conductive contact layers on the semiconductor substrate overlaps with a projection of the bus electrodes on the semiconductor substrate, and the first direction is different from the second direction; and forming collector electrodes extending in the second direction and spaced apart in the first direction, where at least one of the bus electrodes intersects with the collector electrodes.

In the solar cell obtained by performing the method for manufacturing a solar cell provided in the present application, because the projection of at least one of the first conductive contact layers on the semiconductor substrate overlaps with the projection of the bus electrodes on the semiconductor substrate, there is a case in which some of the bus electrodes are in direct contact with the semiconductor substrate or the bus electrodes are not in contact with the semiconductor substrate at all. Based on this, compared with the related art, metal recombination on a surface of the solar cell can be reduced or eliminated, and an open-circuit voltage of the solar cell can be increased, to increase efficiency of the solar cell.

In an implementation, second conductive contact layers extending in the second direction and spaced apart in the first direction are formed on at least one of the first surface or the second surface of the semiconductor substrate. A projection of the collector electrodes on the semiconductor substrate overlaps with a projection of the second conductive contact layers on the semiconductor substrate. At least one of the first conductive contact layers intersects with the second conductive contact layers.

In an implementation, one or more first conductive contact layers are between two adjacent bus electrodes.

In an implementation, a length of a first conductive contact layer between two adjacent bus electrodes is less than or equal to a length of a first conductive contact layer whose projection overlaps with the projection of the bus electrodes on the semiconductor substrate; and/or a width of a first conductive contact layer between two adjacent bus electrodes is less than or equal to a width of a first conductive contact layer whose projection overlaps with the projection of the bus electrodes on the semiconductor substrate; and/or a thickness of a first conductive contact layer between two adjacent bus electrodes is less than or equal to a thickness of a first conductive contact layer whose projection overlaps with the projection of the bus electrodes on the semiconductor substrate.

### BRIEF DESCRIPTION OF THE DRAWINGS

The accompanying drawings described herein are used for providing further understanding of the present application, and constitute a part of the present application. Exemplary embodiments of the present application and descriptions thereof are used for explaining the present application, and do not constitute any inappropriate limitation to the present application. In the accompanying drawings:
FIG. 1 is a schematic structural diagram of first conductive contact layers and second conductive contact layers according to an embodiment of the present application;
FIG. 2 is a schematic structural diagram of collector electrodes, first conductive contact layers, and second conductive contact layers according to an embodiment of the present application;
FIG. 3 is a schematic structural diagram of bus electrodes, collector electrodes, first conductive contact layers, and second conductive contact layers according to an embodiment of the present application;
FIG. 4 is a schematic structural diagram of a solar cell according to an embodiment of the present application;
FIG. 5 is a schematic diagram of series resistance of a solar cell in the related art;
FIG. 6 is a schematic diagram of series resistance of a solar cell according to an embodiment of the present application;
FIG. 7 is a schematic diagram of current flowing directions when only second conductive contact layers are arranged according to an embodiment of the present application;
FIG. 8 is a schematic diagram of current flowing directions when first conductive contact layers and second conductive contact layers are arranged according to an embodiment of the present application;
FIG. 9 is a diagram of a relationship between a solar cell efficiency improvement value and a quantity of first conductive contact layers and second conductive contact layers according to an embodiment of the present application;
FIG. 10 is a diagram of relationships between a width of a fourth conductive contact layer and a fill factor improvement value, a solar cell efficiency improvement value, and a current loss improvement value according to an embodiment of the present application; and
FIG. 11 is a diagram of relationships between a width of a third conductive contact layer and a fill factor improvement value, a solar cell efficiency improvement value, and an open-circuit voltage improvement value according to an embodiment of the present application.

### Reference numerals:

1 - first conductive contact layer, 10 - third conductive contact layer, and 11 - fourth conductive contact layer;
2 - busbar, 3 - finger, and 4 - second conductive contact layer; and
5 - semiconductor substrate, and 6 - contact conductive region.

### DETAILED DESCRIPTION

To make the technical problems to be resolved in the present application, the technical solutions, and beneficial effects more comprehensible, the following further describes the present application in detail with reference to the accompanying drawings and embodiments. It is to be understood that the specific embodiments described herein are merely used to describe the present application, but are not intended to limit the present application.

It is to be noted that, when an element is described as being "fixed to" or "arranged on" another element, the element may be directly located on the another element or indirectly located on the another element. When an element is described as being "connected to" another element, the element may be directly connected to the another element or indirectly connected to the another element.

In addition, the terms "first" and "second" are used for descriptive purposes only and are not to be construed as indicating or implying relative importance or implicitly indicating a number of technical features indicated. Therefore, features defining "first" and "second" may explicitly or implicitly include one or more such features. In the descriptions of the present application, "a plurality of" means two or more, unless otherwise definitely and specifically limited. "Several" means one or more, unless otherwise definitely and specifically limited.

In the descriptions of the present application, it should be understood that orientation or position relationships indicated by the terms such as "upper", "lower", "front", "rear", "left", and "right" are based on orientation or position relationships shown in the accompanying drawings, and are used only for ease and brevity of illustration and description of the present application, rather than indicating or implying that the mentioned apparatus or element needs to have a particular orientation or needs to be constructed and operated in a particular orientation. Therefore, such terms should not be construed as a limitation to the present application.

In the descriptions of the present application, it is to be noted that, unless otherwise explicitly specified or limited, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two elements, or an interaction relationship between two elements. A person of ordinary skill in the art may understand specific meanings of the foregoing terms in the present application according to specific situations.

With reference to Background, for a solar cell, to reduce series resistance and effectively collect a current, a pattern of collector electrodes is usually optimized. For example, a quantity of collector electrodes is increased in a targeted manner, or one small horizontal line is added to two collector electrodes. The small horizontal line is usually referred to as a current guide line, or is referred to as an anti-breakage grid line. However, whether the quantity of collector electrodes is increased or the current guide line is added essentially increases an area of shading a surface of a semiconductor substrate, and in this case, light absorption of the surface of the semiconductor substrate is reduced, and a current is decreased. In addition, a larger quantity of collector electrodes or current guide lines indicates a larger shading area, less light absorption, and a lower current, and in this case, solar cell efficiency may also be lowered.

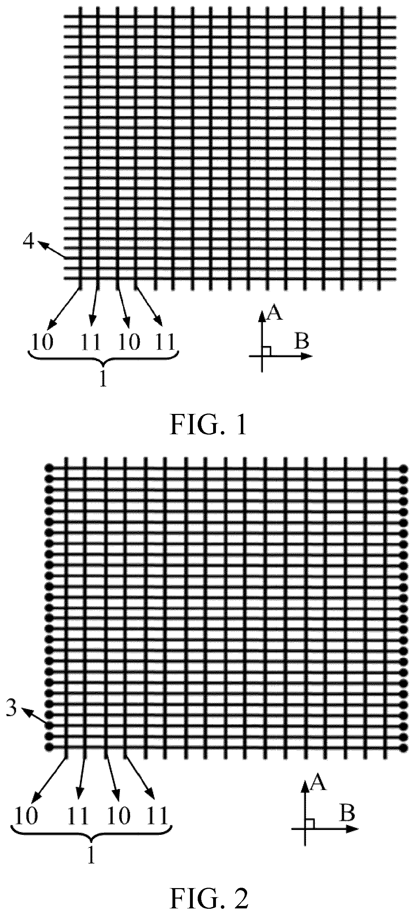

To resolve the foregoing technical problems, according to a first aspect, an embodiment of the present application provides a solar cell. Refer to FIG. 1 to FIG. 3. The solar cell includes: a semiconductor substrate, first conductive contact layers 1, bus electrodes 2, and collector electrodes 3. The semiconductor substrate has a first surface and a second surface opposite to each other. The first conductive contact layers 1 are formed on at least one of the first surface or the second surface of the semiconductor substrate, extend in a first direction A, and are spaced apart in a second direction B. The bus electrodes 2 are disposed on at least one of the first surface or the second surface of the semiconductor substrate. The bus electrodes 2 are formed over the first conductive contact layers 1. The electrodes 2 extend in the first direction A and are spaced apart in the second direction B. A projection of at least one of the first conductive contact layers 1 on the semiconductor substrate overlaps with a projection of the bus electrodes 2 on the semiconductor substrate, and the first direction A is different from the second direction B. A plurality of collector electrodes 3 extend in the second direction and are spaced apart in the first direction. At least one of the bus electrodes intersects with the collector electrodes.

In this specification, the "busbar" is a structure for bus that intersects with the finger; and may be a main gate electrode that intersects with the finger, where the main gate electrode plays a role of collecting currents; or may be a bus bar or an interconnection bar that intersects with the finger, for example, a welding ribbon or a wire, where the bus bar or the interconnection bar is used to replace the main grid electrode and plays the role of collecting the currents.

In the solar cell provided in this embodiment of the present application, because the projection of at least one of the first conductive contact layers 1 on the semiconductor substrate overlaps with the projection of the bus electrodes 2 on the semiconductor substrate, there is a case in which some of the bus electrodes 2 are in direct contact with the semiconductor substrate or the bus electrodes 2 are not in contact with the semiconductor substrate at all. From the perspective of a solar cell structure, first conductive contact layers are locally arranged between a part of the bus electrodes and the solar cell body, to achieve partial direct contact or partial non-contact between the bus electrodes and the solar cell body; and only first conductive contact layers are arranged between the bus electrodes and the solar cell body, to achieve complete non-contact between the bus electrodes and the solar cell body. Based on this, compared with the related art, metal recombination on a surface of the solar cell can be reduced or eliminated, and an open-circuit voltage of the solar cell can be increased, to increase efficiency of the solar cell. It should be understood that the solar cell may be a sliced solar cell, or may be an entire solar cell. Further, the solar cell may be a double-sided solar cell. Furthermore, the projections in the present application are orthographic projections.

"A projection of at least one of the first conductive contact layers on the semiconductor substrate overlaps with a projection of the bus electrodes on the semiconductor substrate" has the following cases. It should be understood that the following descriptions are merely for understanding, and are not intended to constitute a specific limitation.

Example 1: Projections of some of the first conductive contact layers on the semiconductor substrate completely overlap with projections of some of the bus electrodes on the semiconductor substrate.

For example, one possible form is that the solar cell includes five first conductive contact layers and three bus electrodes. Projections of two of the five first conductive contact layers on the semiconductor substrate completely overlap with projections of two of the three bus electrodes on the semiconductor substrate. A quantity of first conductive contact layers is greater than a quantity of bus electrodes, and not all the first conductive contact layers are located under the bus electrodes, and some first conductive contact layers are between the bus electrodes.

Another possible form is that the solar cell includes five first conductive contact layers and five bus electrodes. Projections of two of the five first conductive contact layers on the semiconductor substrate completely overlap with projections of two of the five bus electrodes on the semiconductor substrate. In other words, not all the first conductive contact layers are located under the bus electrodes, and some first conductive contact layers are between the bus electrodes. Further, not all the bus electrodes have first conductive contact layers arranged under the bus electrodes, and there are some bus electrodes having no first conductive contact layer arranged under the bus electrodes.

Still another possible form is that the solar cell includes five first conductive contact layers and three bus electrodes. Projections of three of the five first conductive contact layers on the semiconductor substrate completely overlap with projections of all of the three bus electrodes on the semiconductor substrate. In other words, not all the first conductive contact layers are located under the bus electrodes, and some first conductive contact layers are between the bus electrodes.

Example 2: Projections of some of the first conductive contact layers on the semiconductor substrate partially overlap with projections of some of the bus electrodes on the semiconductor substrate.

For example, one possible form is that the solar cell includes five first conductive contact layers and five bus electrodes. Projections of two of the five first conductive contact layers on the semiconductor substrate partially overlap with projections of two of the five bus electrodes on the semiconductor substrate, that is, the projection of the first conductive contact layer and the projection of the bus electrodes alternately overlap. It can be learned from the above that not all the first conductive contact layers are located under the bus electrodes, and some first conductive contact layers are between the bus electrodes.

Another possible form is that the solar cell includes five first conductive contact layers and three bus electrodes. Projections of two of the five first conductive contact layers on the semiconductor substrate partially overlap with projections of two of the three bus electrodes on the semiconductor substrate, that is, the projection of the first conductive contact layer and the projection of the bus electrodes alternately overlap. A quantity of first conductive contact layers is greater than a quantity of bus electrodes, and not all the first conductive contact layers are located under the bus electrodes, and some first conductive contact layers are between the bus electrodes. Further, not all the bus electrodes have first conductive contact layers arranged under the bus electrodes, and there are some bus electrodes having no first conductive contact layer arranged under the bus electrodes.

Still another possible form is that the solar cell includes five first conductive contact layers and three bus electrodes. Projections of three of the five first conductive contact layers on the semiconductor substrate partially overlap with projections of all of the three bus electrodes on the semiconductor substrate, that is, the projection of the first conductive contact layer and the projection of the bus electrodes alternately overlap. A quantity of first conductive contact layers is greater than a quantity of bus electrodes, and not all the first conductive contact layers are located under the bus electrodes, and some first conductive contact layers are between the bus electrodes.

Example 3: Projections of some of the first conductive contact layers on the semiconductor substrate partially or completely overlap with the projection of the bus electrodes on the semiconductor substrate.

For example, one possible form is that the solar cell includes five first conductive contact layers and five bus electrodes. In this case, a projection of one of the five first conductive contact layers on the semiconductor substrate partially overlaps with a projection of one busbar on the semiconductor substrate. A projection of another of the five first conductive contact layers on the semiconductor substrate completely overlaps with a projection of another busbar on the semiconductor substrate. The another first conductive contact layer may be between the bus electrodes.

Another possible form is that the solar cell includes five first conductive contact layers and three bus electrodes. In this case, a projection of one of the five first conductive contact layers on the semiconductor substrate partially overlaps with a projection of one busbar on the semiconductor substrate. A projection of another of the five first conductive contact layers on the semiconductor substrate completely overlaps with a projection of another busbar on the semiconductor substrate. The another first conductive contact layer may be between the bus electrodes.

Example 4: Projections of all of the first conductive contact layers on the semiconductor substrate overlap with projections of all of the bus electrodes on the semiconductor substrate.

For example, one possible form is that the solar cell includes five first conductive contact layers and five bus electrodes. Projections of the five first conductive contact layers on the semiconductor substrate completely overlap with projections of the five bus electrodes on the semiconductor substrate.

Another possible form is that the solar cell includes five first conductive contact layers and five bus electrodes. Projections of the five first conductive contact layers on the semiconductor substrate partially overlap with projections of the five bus electrodes on the semiconductor substrate, that is, the projection of the first conductive contact layer and the projection of the bus electrodes alternately overlap.

Still another possible form is that the solar cell includes five first conductive contact layers and five bus electrodes. Projections of the five first conductive contact layers on the semiconductor substrate partially or completely overlap with projections of the five bus electrodes on the semiconductor substrate.

In a possible implementation, the first direction and the second direction are any two directions parallel to a surface of the semiconductor substrate and different from each other. In an embodiment, referring to FIG. 1 to FIG. 3, the first direction A and the second direction B are orthogonal.

During actual application, a specific structure of the solar cell may be determined based on an actual application scenario. This is not specifically limited herein. For example, the semiconductor substrate may be only a semiconductor base. For example, the semiconductor base may be a silicon base. In terms of conductivity types, the semiconductor substrate may be an intrinsic conductive substrate, an N-type conductive substrate, or a P-type conductive substrate. In an embodiment, the semiconductor substrate is an N-type conductive substrate or a P-type conductive substrate. Compared with the intrinsic conductive substrate, the N-type conductive substrate or the P-type conductive substrate has higher electrical conductivity, which helps reduce series resistance of the solar cell and increase the efficiency of the solar cell. In terms of the structure, when the first surface of the semiconductor substrate is a light-receiving surface, and the second surface is a back surface, the first surface of the semiconductor substrate may be a textured surface, to improve a light trapping effect of the light-receiving surface of the solar cell, so as to improve light utilization of the solar cell. Certainly, the first surface of the semiconductor substrate may alternatively be a plane. The second surface of the semiconductor substrate may be a polished surface, or may be a textured surface. This is not specifically limited herein.

The first conductive contact layers 1 and the bus electrodes 2, and the collector electrodes 3 and second conductive contact layers 4 may be formed on the first surface and/or the second surface of the semiconductor substrate. When the first conductive contact layers 1 and the bus electrodes 2, and the collector electrodes 3 and the second conductive contact layers 4 are formed on one surface of the semiconductor substrate, a structure of the other surface of the semiconductor substrate may be selected based on needs. For example, when the first conductive contact layers 1 and the bus electrodes 2, and the collector electrodes 3 and the second conductive contact layers 4 are formed on the light-receiving surface of the semiconductor substrate, the back surface of the semiconductor substrate from the silicon base to the outside may be a full-area tunnel oxide layer, a full-area doped polysilicon layer, a passivation layer, or an electrode. In another case, the back surface of the semiconductor substrate from the silicon base to the outside may be a passivation layer or an electrode.

The following describes the solar cell provided in the present application by using three possible cases as examples. It should be understood that the following descriptions are merely for understanding, and are not intended to constitute a specific limitation.

Example 1: From the second surface to the first surface of the semiconductor substrate, the solar cell may sequentially include electrodes (where the electrodes include bus electrodes and collector electrodes), the semiconductor substrate, conductive contact layers (where the conductive contact layers include first conductive contact layers and second conductive contact layers), and electrodes (where the electrodes include bus electrodes and collector electrodes).

Example 2: From the second surface to the first surface of the semiconductor substrate, the solar cell may sequentially include electrodes (where the electrodes include bus electrodes and collector electrodes), conductive contact layers (where the conductive contact layers include first conductive contact layers and second conductive contact layers), the semiconductor substrate, and electrodes (where the electrodes include bus electrodes and collector electrodes).

Example 3: From the second surface to the first surface of the semiconductor substrate, the solar cell may sequentially include electrodes (where the electrodes include bus electrodes and collector electrodes), conductive contact layers (where the conductive contact layers include first conductive contact layers and second conductive contact layers), the semiconductor substrate, conductive contact layers (where the conductive contact layers include first conductive contact layers and second conductive contact layers), and electrodes (where the electrodes include bus electrodes and collector electrodes).

It should be understood that, based on actual needs, the solar cell may further include other film layers in the related art, for example, an aluminum oxide layer and a silicon nitride layer.

In an optional implementation, conductive contact layers located on at least either of the back surface and the light-receiving surface of the semiconductor substrate is of a partial structure (referring to FIG. 1).

In an optional implementation, conductive contact layers located on the back surface of the semiconductor substrate may be of a full-area structure or a partial structure (referring to FIG. 1). It should be understood that the full-area structure means that the conductive contact layers completely cover the back surface of the semiconductor substrate.

In a possible implementation, referring to FIG. 1 to FIG. 3, the solar cell further includes second conductive contact layers 4. The second conductive contact layers 4 extend in the second direction B and are spaced apart in the first direction A. A projection of the collector electrodes 3 on the semiconductor substrate overlaps with a projection of the second conductive contact layers 4 on the semiconductor substrate. At least one of the first conductive contact layers intersects with the second conductive contact layers.

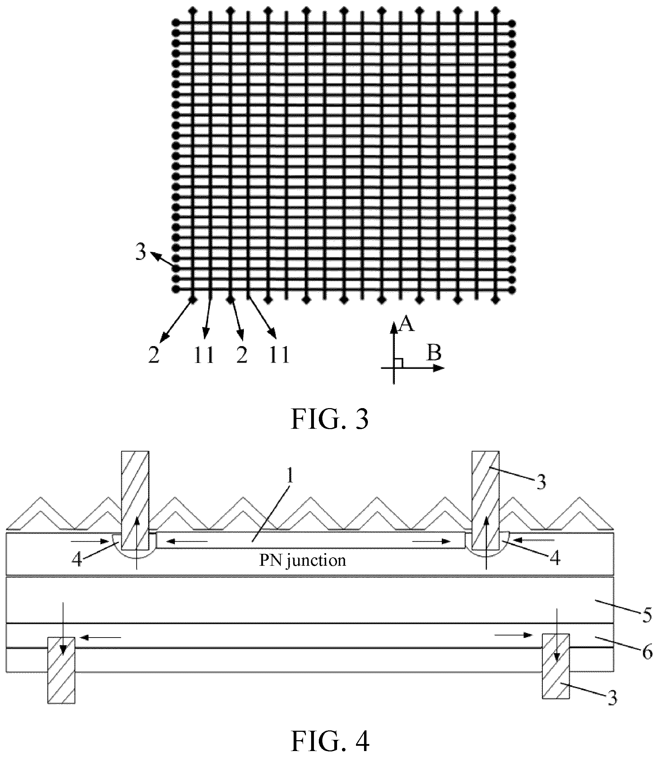

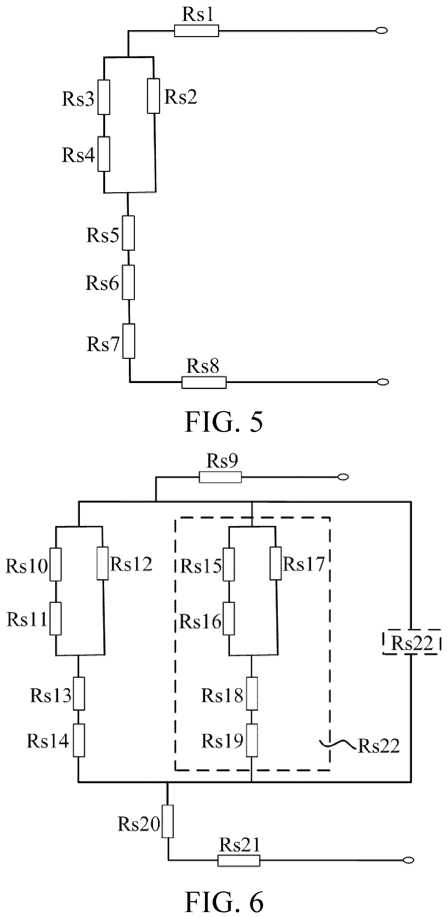

When the foregoing technical solution is adopted, with reference to the foregoing descriptions, the solar cell includes the first conductive contact layer and the second conductive contact layer. In this way, both contact resistivity and series resistance can be reduced, and a current can be effectively collected, to increase the efficiency of the solar cell. In addition, a transport distance of carriers can be reduced, to reduce a recombination loss of the carriers during transport. For example, the contact resistivity is decreased by 0.1 mΩ*cm² to 2 mΩ*cm², and the series resistance is decreased by 0.05 mΩ to 0.5 mΩ. FIG. 5 and FIG. 6 are schematic diagrams of comparison between series resistance of a solar cell in the related art and series resistance of a solar cell according to an embodiment of the present application. Referring to FIG. 4 to FIG. 6, in the embodiments of the present application, a front surface, namely, the light-receiving surface, of the solar cell is mainly alleviated, and contact resistance in a back surface region remains unchanged. Therefore, back surface contact resistance, that is, a resistance value of the semiconductor substrate, a resistance value of bus electrodes in a contact conductive region, and a resistance value of contact between electrodes remain unchanged. Rs1 represents a contact resistance value between the collector electrodes and the bus electrodes in a conductive region on a front surface of the semiconductor substrate, Rs2 represents a resistance value of contact in a direction from a lowest portion of the first conductive contact layer to the bus electrodes, Rs3 represents a resistance value in a direction from a surface of a PN junction region, that is, a top layer of the light-receiving surface of the semiconductor substrate to the bus electrodes, Rs4 represents a resistance value in directions from the leftmost and rightest of the first conductive contact layer to the bus electrodes, Rs5 represents a resistance value in a direction from the first conductive contact layer and the second conductive contact layer to the bus electrodes, Rs6 represents a resistance value of contact between metal and the semiconductor substrate formed by the first conductive contact layer and the bus electrodes, Rs7 represents a resistance value of collector electrodes on a back surface, and Rs8 represents a resistance value of bus electrodes on the back surface.

Rs9 represents a contact resistance value between the collector electrodes and the bus electrodes in a conductive region on a front surface of the semiconductor substrate, Rs12 represents a resistance value in a direction from a lowest portion of the first conductive contact layer to the bus electrodes, Rs10 represents a resistance value in a direction from a surface of a PN junction region, that is, a top layer of the light-receiving surface of the semiconductor substrate to the bus electrodes, Rs11 represents a resistance value in directions from the leftmost and rightest of the first conductive contact layer to the bus electrodes, Rs13 represents a resistance value in a direction from the first conductive contact layer and the second conductive contact layer to the bus electrodes, Rs14 represents a resistance value of contact between metal and the semiconductor substrate formed by the first conductive contact layer and the bus electrodes, Rs20 represents a resistance value of the collector electrodes, and Rs21 represents a resistance value of the bus electrodes. Rs15, Rs16, Rs17, Rs18, and Rs19 are circuits that are generated after the second conductive contact layer is added and that are connected with the first conductive contact layer in parallel. Rs15 represents a resistance value in a direction from the surface of the N junction region to the second conductive contact layer, Rs16 represents a resistance value in a direction from the second conductive contact layer to the bus electrodes, Rs17 represents a resistance value in a direction from a lowest portion of the second conductive contact layer to an uppermost portion of the second conductive contact layer, Rs18 represents a resistance value in a direction from the semiconductor substrate to the second conductive contact layer, Rs19 represents a resistance value of contact between the second conductive contact layer and metal, and Rs22 represents a resistance value increased each time one second conductive contact layer is added. The contact conductive region 6 located on the semiconductor substrate 5 has a conduction type opposite to that of the first conductive contact layer 1. Further, arrows in FIG. 4 point to transport directions of the photogenerated carriers.

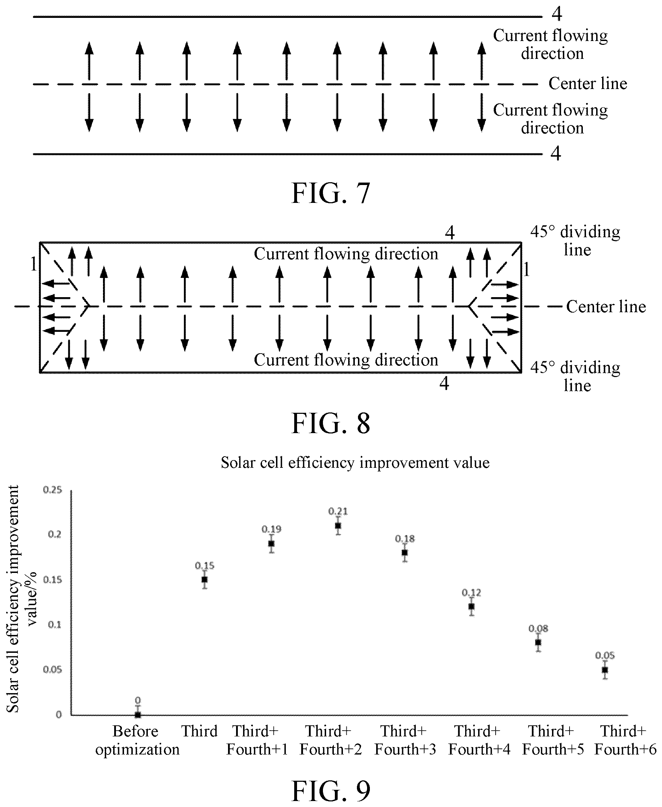

Further, FIG. 7 shows current flowing directions when only second conductive contact layers 4 are arranged. FIG. 8 shows current flowing directions when both first conductive contact layers 1 and second conductive contact layers 4 are arranged. It can be learned that, when both the first conductive contact layer 1 and the second conductive contact layer 4 are arranged, a transport distance of a current can be further reduced, to reduce a current loss.

Furthermore, a projection of the collector electrodes on the semiconductor substrate overlaps with a projection of the second conductive contact layer on the semiconductor substrate. In this case, it may be understood as that the projection of the collector electrodes on the semiconductor substrate is located within a boundary of the projection of the second conductive contact layer on the semiconductor substrate. In an embodiment, the projection of the collector electrodes on the semiconductor substrate completely overlaps with the projection of the second conductive contact layer on the semiconductor substrate, and when two projection areas are completely equal, shading by the second conductive contact layers on the semiconductor substrate can be avoided, to avoid impact on light absorption of the semiconductor substrate, so as to increase the efficiency of the solar cell.

In a possible implementation, a width of the second conductive contact layer ranges from 30 µm to 200 µm, a length is slightly less than that of the semiconductor substrate, and a thickness ranges from 30 nm to 600 nm.

In a possible implementation, the first conductive contact layer and the second conductive contact layer may include P-type doped polysilicon layers and tunneling layers, or may include N-type doped polysilicon layers and tunneling layers. For example, the tunneling layer may be a silicon dioxide tunneling layer. The tunneling layer is formed on the semiconductor substrate, and the P-type doped polysilicon layer or the N-type doped polysilicon layer is formed on the tunneling layer. Such a structure not only has a good function of passivating a dangling bond on a silicon surface, but also may also have a function of providing an electric field, so that most carriers form currents under the action of the electric field, and few carriers are prevented from moving to the surface and being recombined. In addition, recombination of metal in contact with a metal-semiconductor of such a structure is low, and therefore, a passivation effect of the solar cell can be improved. Further, improvement of the passivation effect can significantly increase the open-circuit voltage of the solar cell, so that the efficiency of the solar cell can be improved.

For example, compared with the related art, metal recombination (that is, a recombination current density of a metal contact region) is reduced by 1 fA to 20 fA, and the open-circuit voltage is increased by 1 mV to 10 mV.

For a metal recombination loss, contact between metal and a semiconductor is not a simple connection between metal and the semiconductor, but metal and the semiconductor form a metal-semiconductor alloy. In a process of forming the alloy, in addition to the alloy, some scattered metal powders are free in the semiconductor. The metal powders in such a state in the semiconductor are deep-level impurities, do not participate in electrical conduction, and serve as recombination centers to trap electrons transported from a valence band to a guide band, resulting in severe metal recombination. Because the first conductive contact layers and the second conductive contact layers have high doping concentrations and can form an alloy together with a large amount of metal, generated free metal particles are small. In addition, because the first conductive contact layer and the second conductive contact layer have a doped polysilicon layer and a tunneling layer and metal generally does not pass through the tunneling layer to come into contact with a silicon substrate (that is, the semiconductor substrate), the metal recombination is reduced.

In a possible implementation, referring to FIG. 3, one or more first conductive contact layers are between two adjacent bus electrodes. A first conductive contact layer is also between two adjacent bus electrodes. In this case, the transport distance of the carriers can be further reduced, to further reduce the recombination loss of the carriers during transport. Specifically, the carriers are recombined by impurity defects during transport. Therefore, the transport distance is reduced, and the recombination loss of the carriers is reduced.

For example, the current loss, a shading loss, and the metal recombination loss are collectively referred to as a total loss. A total loss of the solar cell in the related art ranges from 300 mA to 500 mA, and a total loss of the solar cell provided in the embodiments of the present application ranges from 300 mA to 450 mA, and an average recombination current loss of a monolithic solar cell is decreased by 5 mA to 100 mA.

For ease of later description, the "first conductive contact layer whose projection overlaps with the projection of the bus electrodes on the semiconductor substrate" is defined as a third conductive contact layer, and the "first conductive contact layer between two adjacent bus electrodes" is defined as a fourth conductive contact layer. In other words, the first conductive contact layer includes the third conductive contact layer and the fourth conductive contact layer.

For example, a quantity of fourth conductive contact layers is greater than or equal to 1 and less than or equal to 5. For example, the quantity of fourth conductive contact layers may be 1, 2, 3, 4, or 5. When the quantity of fourth conductive contact layers is less than or equal to 5, shading by the fourth conductive contact layers on the semiconductor substrate can be reduced, to reduce impact on light absorption of the semiconductor substrate, and increase the efficiency of the solar cell.

In a possible implementation, referring to FIG. 9, it is assumed that when the first conductive contact layer is not arranged (for ease of description of a horizontal coordinate in the figure, the horizontal coordinate is represented by "before optimization"), the efficiency of the solar cell has a reference value of 0. When only the third conductive contact layer is arranged (where a horizontal coordinate in the figure is represented by "third"), compared with the efficiency of the solar cell before optimization, in this case, the efficiency of the solar cell is increased. When the quantity of fourth conductive contact layers is continuously increased on a basis that a quantity of third conductive contact layers remains unchanged (that is, the quantity of third conductive contact layers remains unchanged to maintain a single variable) (where a horizontal coordinate in the figure is represented by "quantities of third+fourth+fourth conductive contact layers", "the quantity of fourth conductive contact layers" is represented by using a number such as "1, 2, or 3"), the quantity of fourth conductive contact layers is increased to a specific value, and a gain for reduction of the metal recombination loss is less than a current loss caused by shading, and consequently, the efficiency of the solar cell is no longer increased.

In a possible implementation, referring to FIG. 3, a width of the first conductive contact layer (that is, a fourth conductive contact layer 11) between two adjacent bus electrodes is greater than or equal to 10 µm and less than or equal to 150 µm, and the width of the first conductive contact layer is measured along the second direction. For example, the width of the fourth conductive contact layer 11 may be 10 µm, 20 µm, 50 µm, 80 µm, 100 µm, 150 µm, or the like.

In this case, shading by the fourth conductive contact layers 11 on the semiconductor substrate can be reduced, to reduce impact on light absorption of the semiconductor substrate, and increase the efficiency of the solar cell. In addition, the passivation effect on the solar cell can be improved. Further, a transport distance of a current can be reduced, to reduce a current loss.

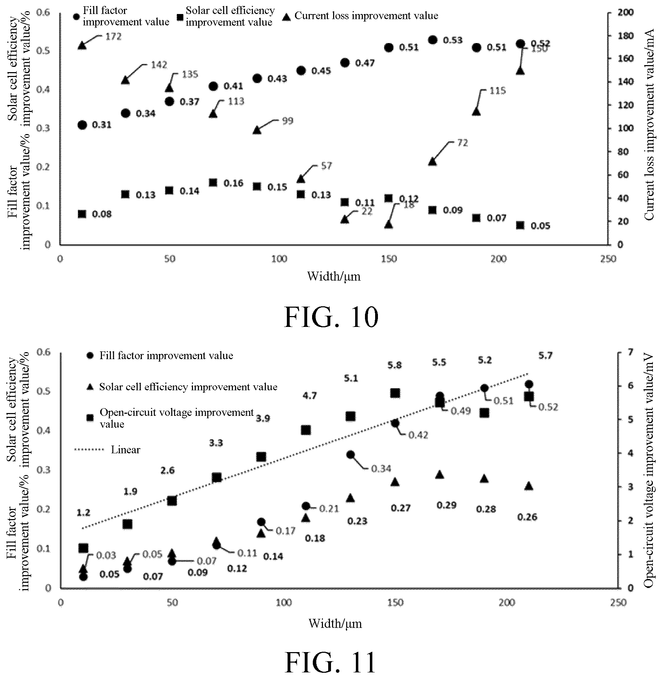

In a possible implementation, referring to FIG. 10, when only the fourth conductive contact layer 11 is considered, only one first conductive contact layer (that is, one fourth conductive contact layer 11) may be arranged between every two adjacent bus electrodes. When a plurality of first conductive contact layers are arranged between every two adjacent bus electrodes, it may be approximately considered as splicing of a plurality of narrow lines. In this case, it can be found that as the width of the fourth conductive contact layer 11 is increased, the current loss is first decreased and then increased. Because the width of the fourth conductive contact layer 11 cannot be excessively large, although the fourth conductive contact layer may achieve a particular passivation benefit, and may reduce a recombination loss due to shortening of a transport distance in a carrier transport process, the fourth conductive contact layers 11 may also cause a shading loss due to parasite absorption. Only when the fourth conductive contact layer is within a specific range, the passivation effect of the solar cell is optimal, the open-circuit voltage of the solar cell is increased, the transport distance becomes shorter, and the current is increased. In addition, a shading area is not large, and a current loss caused by shading is small. In other words, the open-circuit voltage of the solar cell is increased, and a gain for reduction of the recombination loss during transport is greater than the current loss caused by shading, so that the solar cell efficiency is increased.

In a possible implementation, referring to FIG. 2, a width of a first conductive contact layer (that is, a third conductive contact layer 10) whose projection overlaps with the projection of the bus electrodes on the semiconductor substrate is greater than or equal to 50 µm and less than or equal to 300 µm, and the width of the first conductive contact layer is measured along the second direction. For example, the width of the third conductive contact layer 10 may be 50 µm, 80 µm, 100 µm, 180 µm, 240 µm, 300 µm, or the like.

In this case, impact of a material of the bus electrodes on an area of the surface of the semiconductor substrate can be reduced, or impact of the material of the bus electrodes on the surface of the semiconductor substrate can be avoided. Further, in addition to having a passivation surface function, the first conductive contact layer further needs to have a function of collecting a current collected by the collector electrodes. Because metal used in the solar cell in the present application is usually a metal paste, the used metal material is usually metal power with a specific particle size, when metal-semiconductor alloy is formed, vertical etching is prone to occur. Based on this, the first conductive contact layer needs to have a specific thickness, to prevent metal from burning through the first conductive contact layer and being in direct contact with the semiconductor substrate. Therefore, the first conductive contact layer whose projection overlaps with the projection of the bus electrodes on the semiconductor substrate needs to have a specific thickness, to achieve a barrier function, so as to suppress metal recombination. In addition, a main function of a first conductive contact layer other than the first conductive contact layers directly under the bus electrodes is to assist the second conductive contact layer in collecting a current, to reduce the transport distance of the carriers, so as to reduce the recombination loss. However, because parasite absorption of the first conductive contact layer is strong (that is, when light passes through the first conductive contact layer, most light energy is absorbed by the first conductive contact layer without generating a large quantity of photogenerated carriers at a PN junction, and ineffective absorption is significant, resulting in a current loss), a thick first conductive contact layer causes reduction of the current. Further, when the width of the first conductive contact layer is less than 50 µm, the first conductive contact layer is likely to be removed in a cleaning process. When the width of the first conductive contact layer is less than a width of the bus electrodes, the first conductive contact layer cannot effectively collect a current. When the first conductive contact layer is of an incomplete structure, the first conductive contact layer cannot assist in transport, and even affects surface passivation. Furthermore, if the width of the first conductive contact layer is excessively large, light is severely shaded, causing reduction of the current.

In a possible implementation, referring to FIG. 11, when only a width of the third conductive contact layer is considered, optimal efficiency is obtained when the width of the third conductive contact layer is close to the width of the bus electrodes (in this case, the current loss and the shading loss are not considered). When the width of the third conductive contact layer is excessively small, the gain for reduction of the metal recombination loss is excessively small, and consequently, improvement of the open-circuit voltage and improvement of a fill factor are limited. When the width of the third conductive contact layer is excessively large, the shading loss is large.

In a possible implementation, a length of a first conductive contact layer whose projection overlaps with the projection of the bus electrodes on the semiconductor substrate is less than a length of the semiconductor substrate and greater than a length of a bus electrode; and a width of a first conductive contact layer whose projection overlaps with the projection of the bus electrodes on the semiconductor substrate is greater than a width of a bus electrode.

When the foregoing technical solution is adopted, complete direct contact between the bus electrodes and the semiconductor substrate can be reduced or avoided in terms of the length and the width, so that metal recombination on the surface of the solar cell can be reduced or eliminated, and an open-circuit voltage of the solar cell can be increased, to increase efficiency of the solar cell.

In a possible implementation, a length of a first conductive contact layer between two adjacent bus electrodes is less than or equal to a length of a first conductive contact layer whose projection overlaps with the projection of the bus electrodes on the semiconductor substrate; and/or a width of a first conductive contact layer between two adjacent bus electrodes is less than or equal to a width of a first conductive contact layer whose projection overlaps with the projection of the bus electrodes on the semiconductor substrate; and/or a thickness of a first conductive contact layer between two adjacent bus electrodes is less than or equal to a thickness of a first conductive contact layer whose projection overlaps with the projection of the bus electrodes on the semiconductor substrate.

When the foregoing technical solution is adopted, for the entire solar cell, an entire current collection process is that the surface of the solar cell is irradiated, a large quantity of photogenerated carriers are generated at the PN junction inside the solar cell, the photogenerated carriers are transferred to P regions and N regions or dope regions under the action of a built-in electric field to be separated to the surface, and all carriers that do not undergo recombination and that are collected on the surface of the semiconductor substrate are collected in a first conductive contact region in which the surface is in metal contact with the dope region. Therefore, to better collect a current, the first conductive contact regions should cover the entire surface of the semiconductor substrate base as much as possible. Therefore, the length of the first conductive contact layer should be long. However, an upper portion of the first conductive contact layer is irradiated, and parasite absorption of the first conductive contact layer is strong, that is, ineffective absorption is significant. In consideration of the foregoing situation, because it is necessary to prevent metal from etching the semiconductor substrate downward toward the edge, the first conductive contact layers under the bus electrodes need to have a larger width and thickness. The length, width, and thickness of the first conductive contact layers between the bus electrodes should be less than a length, width, and thickness of first conductive contact layers in other regions.

Because the first conductive contact layer between two adjacent bus electrodes has a current transfer function, there is no need to prevent complete direct contact between the bus electrodes and the semiconductor substrate. Therefore, the length, the width, and the thickness of the first conductive contact layer between two adjacent bus electrodes may be smaller than that of the first conductive contact layer whose projection overlaps with the projection of the bus electrodes on the semiconductor substrate, to save manufacturing materials and reduce costs.

In a possible implementation, a thickness of a first conductive contact layer whose projection overlaps with the projection of the bus electrodes on the semiconductor substrate is greater than or equal to 30 nm and less than or equal to 600 nm, and the thickness of the first conductive contact layer is measured along a direction from a first surface to a second surface of the semiconductor substrate. For example, the thickness of the first conductive contact layers may be 30 nm, 50 nm, 180 nm, 200 nm, 380 nm, 460 nm, 600 nm, or the like.

The thickness of the first conductive contact layer is greater than or equal to 30 nm, so that a probability that the material for manufacturing the bus electrodes burns through the semiconductor substrate can be reduced or eliminated, to reduce or eliminate the metal recombination on the surface of the solar cell, so as to increase the efficiency of the solar cell. Further, because parasite absorption of the first conductive contact layer is strong (that is, when light passes through the first conductive contact layer, most light energy is absorbed by the first conductive contact layer without generating a large quantity of photogenerated carriers, and ineffective absorption is significant, resulting in a current loss), a thick first conductive contact layer causes reduction of the current. Therefore, the thickness of the first conductive contact layer needs to be less than or equal to 600 nm.

In an optional implementation, the at least one first conductive contact layer whose projection overlaps with the projection of the bus electrodes on the semiconductor substrate has a first area, and a ratio of the first area to a sum of an area of the first conductive contact layers and an area of the second conductive contact layers is greater than or equal to 0.1% and less than or equal to 5%. For example, the ratio may be 0.1%, 0.6%, 1%, 1.5%, 2.5%, 3.6%, 4%, 5%, or the like.

Theoretically, it is an optimal solution in which the bus electrodes completely cover the first conductive contact layer whose projection overlaps with the projection of the bus electrodes on the semiconductor substrate. However, in an actual manufacturing process, except for a few metal processes that are high-cost and are not completely mature, such as galvanization and evaporation, it is impossible to achieve complete coverage in a conventional metallization solution. Therefore, in an existing overprinting situation, obtained solar cell efficiency is optimal within the foregoing range.

In a possible implementation, the at least one first conductive contact layer whose projection overlaps with the projection of the bus electrodes on the semiconductor substrate has a first area, first conductive contact layers that are each between two adjacent bus electrodes has a second area, and a ratio of the second area to the first area is greater than or equal to 5% and less than or equal to 20%. For example, the ratio may be 5%, 6%, 7%, 10%, 12%, 13%, 15%, 20%, or the like.

When the foregoing technical solution is adopted, the passivation effect, parasite absorption, current collection, and contact between metal and the semiconductor substrate are all considered. Within the foregoing range, the passivation effect is optimal, the parasite absorption is small, more currents are collected, the contact between metal and the semiconductor substrate is good, and metal recombination is reduced, so that the optimal cell efficiency is obtained.

In a possible implementation, a ratio of a sum of areas of first conductive contact layers and second conductive contact layers that are formed on the first surface of the semiconductor substrate to an area of the first surface of the semiconductor substrate is greater than or equal to 5% and less than or equal to 15%, for example, the ratio may be 5%, 6%, 7%, 8%, 9%, 10%, 15%, or the like; and/or a ratio of a sum of areas of first conductive contact layers and second conductive contact layers that are formed on the second surface of the semiconductor substrate to an area of the second surface of the semiconductor substrate is greater than or equal to 5% and less than or equal to 15%, for example, the ratio may be 5%, 6%, 7%, 8%, 9%, 10%, 15%, or the like. In this case, the open-circuit voltage, a short-circuit current, and the fill factor of the solar cell all may be considered, to increase the efficiency of the solar cell.

When the foregoing technical solution is adopted, an area covered by conductive contact layers cannot be excessively large for the entire solar cell, and an excessively large area covered by the conductive contact layers reduces light absorption of the entire solar cell, and reduces generation of photogenerated carriers. In addition, photogenerated carriers generated on the entire solar cell also need to be collected. Considering efficiency of collecting the photogenerated carriers, the conductive contact layers should cover the entire surface as much as possible. However, considering disadvantages brought by shading of the conductive contact layers, the entire surface cannot be completely covered. In comprehensive consideration of the foregoing aspects, the first conductive contact layers and the second conductive contact layers are connected into a mesh. This not only avoids excessive shading, but also ensures current collection. In addition, good passivation effects of the first conductive contact layer and the second conductive contact layer can improve the passivation effect of the entire solar cell. However, an excessively small area covered by the conductive contact layers may cause a current collection path to be prolonged, and cause the series resistance to be increased, resulting in an increase in a recombination loss. A higher doping concentration of the first conductive contact layers and the second conductive contact layers is beneficial to forming good contact between metal and the semiconductor substrate, and a lower doping concentration is beneficial to reduction of recombination. Therefore, an area proportion and the doping concentration need to be comprehensively considered, so that the open-circuit voltage, a short-circuit current, and a fill factor of the solar cell are all considered, to form a solar cell structure with high solar cell efficiency.

It should be understood that an area of the first conductive contact layers is obtained by multiplying a length by a width of each first conductive contact layer and then multiplying by the quantity of first conductive contact layers. An area of the second conductive contact layers is obtained by multiplying a length by a width of each second conductive contact layer and then multiplying by a quantity of second conductive contact layers.

In a possible implementation, the contact resistivity and the series resistance of the solar cell are decreased as the quantity of first conductive contact layers is increased. Specifically, it is assumed that when the first conductive contact layer is not arranged, the contact resistivity and the series resistance have reference values. When only the third conductive contact layers are arranged, the contact resistivity and the series resistance are decreased. When the quantity of fourth conductive contact layers is continuously increased on a basis that a quantity of third conductive contact layers remains unchanged (that is, the quantity of third conductive contact layers remains unchanged to maintain a single variable), a magnitude of a decrease in the contact resistivity becomes increasingly larger, and a magnitude of a decrease in the series resistance also becomes increasingly larger.

In a possible implementation, because the series resistance is decreased, the fill factor (FF) of the solar cell is significantly improved in this case. For example, improvement of the fill factor is significantly increased by 0.1% to 0.8%.

In a possible implementation, when the first conductive contact layer is not arranged (which is subsequently represented by "before optimization" for ease of description), the current loss is large due to shading of the bus electrodes and the collector electrodes. When only the third conductive contact layers are arranged, the current loss is reduced compared with that before optimization. When the quantity of fourth conductive contact layers is continuously increased on a basis that a quantity of third conductive contact layers remains unchanged (that is, the quantity of third conductive contact layers remains unchanged to maintain a single variable), the current loss is continuously increased compared with compared with the current loss before optimization and the current loss when only the third conductive contact layer is arranged. The quantity of third conductive contact layers is the same as the quantity of bus electrodes. Excessive bus electrodes may shade the semiconductor substrate. An excessively large shading area may cause a current decrease. The quantity of fourth conductive contact layers may be greater than the quantity of third conductive contact layers. In this case, the quantity of fourth conductive contact layers may be increased by reducing the width of the fourth conductive contact layers. Under the same shading conditions, carrier recombination during transport is reduced by reducing the transport distance.

In a possible implementation, it is assumed that when the first conductive contact layer is not arranged (which is subsequently represented by "before optimization" for ease of description), the passivation effect of the solar cell has a reference effect. When only the third conductive contact layer is arranged, the passivation effect of the solar cell is improved compared with that before optimization. It can be known according to common knowledge that a passivation effect of a region where the first conductive contact layers are located is better than a passivation effect of a region in which no first conductive contact layer is arranged. When the quantity of fourth conductive contact layers is continuously increased on a basis that a quantity of third conductive contact layers remains unchanged (that is, the quantity of third conductive contact layers remains unchanged to maintain a single variable), the passivation effect of the solar cell is continuously improved. It should be understood that the passivation effect is reflected by photoluminescent luminance.

In a possible implementation, it is assumed that when the first conductive contact layer is not arranged (which is subsequently represented by "before optimization" for ease of description), metal recombination JOmetal has a reference value. When only the third conductive contact layer is arranged, compared with metal recombination before optimization, the metal recombination JOmetal is obviously reduced. When the quantity of fourth conductive contact layers is continuously increased on a basis that a quantity of third conductive contact layers remains unchanged (that is, the quantity of third conductive contact layers remains unchanged to maintain a single variable), a magnitude of reduction of the metal recombination JOmetal does not greatly change. It can be learned from the above that, the metal recombination JOmetal only decreases obviously when only the third conductive contact layer is arranged, because a recombination loss is large when the bus electrodes made of metal is in contact with the semiconductor substrate on which the first conductive contact layers are not arranged. However, when the first conductive contact layers (that is, the third conductive contact layers) are arranged directly under the bus electrodes, the metal recombination loss is small.

According to a second aspect, an embodiment of the present application further provides a method for manufacturing a solar cell. The method for manufacturing a solar cell includes:
providing a semiconductor substrate, where the semiconductor substrate has a first surface and a second surface opposite to each other;
forming, on at least one of the first surface or the second surface of the semiconductor substrate, first conductive contact layers extending in a first direction and spaced apart in a second direction;
forming, on the first conductive contact layers, bus electrodes extending in the first direction and spaced apart in the second direction, where a projection of at least one of the first conductive contact layers on the semiconductor substrate overlaps with a projection of the bus electrodes on the semiconductor substrate, and the first direction is different from the second direction; and forming collector electrodes extending in the second direction and spaced apart in the first direction, where at least one of the bus electrodes intersects with the collector electrodes.

In the solar cell obtained by performing the method for manufacturing a solar cell provided in the embodiments of the present application, because the projection of at least one of the first conductive contact layers on the semiconductor substrate overlaps with the projection of the bus electrodes on the semiconductor substrate, there is a case in which some of the bus electrodes are in direct contact with the semiconductor substrate or the bus electrodes are not in contact with the semiconductor substrate at all. Based on this, compared with the related art, metal recombination on a surface of the solar cell can be reduced or eliminated, and an open-circuit voltage of the solar cell can be increased, to increase efficiency of the solar cell.

In a possible implementation, the solar cell may be a double-sided solar cell.

In a possible implementation, second conductive contact layers extending in the second direction and spaced apart in the first direction are formed on at least one of the first surface or the second surface of the semiconductor substrate. A projection of the collector electrodes on the semiconductor substrate overlaps with a projection of the second conductive contact layers on the semiconductor substrate. At least one of the first conductive contact layers intersects with the second conductive contact layers.

In a possible implementation, one or more first conductive contact layers are between two adjacent bus electrodes.

In a possible implementation, a length of a first conductive contact layer between two adjacent bus electrodes is less than or equal to a length of a first conductive contact layer whose projection overlaps with the projection of the bus electrodes on the semiconductor substrate; and/or a width of a first conductive contact layer between two adjacent bus electrodes is less than or equal to a width of a first conductive contact layer whose projection overlaps with the projection of the bus electrodes on the semiconductor substrate; and/or a thickness of a first conductive contact layer between two adjacent bus electrodes is less than or equal to a thickness of a first conductive contact layer whose projection overlaps with the projection of the bus electrodes on the semiconductor substrate.

For detailed descriptions of the foregoing content, refer to the first aspect, and details are not described herein again.

In the descriptions of the foregoing implementations, the described specific features, structures, materials, or characteristics may be combined in a proper manner in any one or more of the embodiments or examples. The foregoing descriptions are merely specific implementations of the present application, but are not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. A solar cell, comprising:
a semiconductor substrate, having a first surface and a second surface opposite to each other;
first conductive contact layers disposed on at least one of the first surface or the second surface of the semiconductor substrate, wherein the first conductive contact layers extend in a first direction and are spaced apart in a second direction;
bus electrodes, disposed on at least one of the first surface or the second surface of the semiconductor substrate, wherein the bus electrodes are over the first conductive contact layers; the bus electrodes extend in the first direction and are spaced apart in the second direction; and a projection of at least one of the first conductive contact layers on the semiconductor substrate overlaps with a projection of the bus electrodes on the semiconductor substrate, and the first direction is different from the second direction; and
collector electrodes extending in the second direction and spaced apart in the first direction, wherein at least one of the bus electrodes intersects with the collector electrodes.

2. The solar cell according to claim 1, wherein the solar cell further comprises:
second conductive contact layers extending in the second direction and spaced apart in the first direction, wherein a projection of the collector electrodes on the semiconductor substrate overlaps with a projection of the second conductive contact layers on the semiconductor substrate; and
at least one of the first conductive contact layers intersects with the second conductive contact layers.

3. The solar cell according to claim 1, wherein one or more first conductive contact layers are between two adjacent bus electrodes.

4. The solar cell according to claim 1 or 3, wherein a width of a first conductive contact layer between two adjacent bus electrodes is greater than or equal to 10 µm and less than or equal to 150 µm; and the width of the first conductive contact layer is measured along the second direction.

5. The solar cell according to claim 1, wherein a width of a first conductive contact layer whose projection overlaps with the projection of the bus electrodes on the semiconductor substrate is greater than or equal to 50 µm and less than or equal to 300 µm; and the width of the first conductive contact layer is measured along the second direction.

6. The solar cell according to claim 1, wherein a length of a first conductive contact layer whose projection overlaps with the projection of the bus electrodes on the semiconductor substrate is less than a length of the semiconductor substrate and greater than a length of a bus electrode; and
a width of a first conductive contact layer whose projection overlaps with the projection of the bus electrodes on the semiconductor substrate is greater than a width of a bus electrode.

7. The solar cell according to claim 1, wherein a length of a first conductive contact layer between two adj acent bus electrodes is less than or equal to a length of a first conductive contact layer whose projection overlaps with the projection of the bus electrodes on the semiconductor substrate; and/or
a width of a first conductive contact layer between two adjacent bus electrodes is less than or equal to a width of a first conductive contact layer whose projection overlaps with the projection of the bus electrodes on the semiconductor substrate; and/or
a thickness of a first conductive contact layer between two adjacent bus electrodes is less than or equal to a thickness of a first conductive contact layer whose projection overlaps with the projection of the bus electrodes on the semiconductor substrate.

8. The solar cell according to claim 1, wherein a thickness of a first conductive contact layer whose projection overlaps with the projection of the bus electrodes on the semiconductor substrate is greater than or equal to 30 nm and less than or equal to 600 nm; and the thickness of the first conductive contact layer is measured along a direction from the first surface to the second surface of the semiconductor substrate.

9. The solar cell according to claim 2, wherein the at least one first conductive contact layer whose projection overlaps with the projection of the bus electrodes on the semiconductor substrate has a first area, and a ratio of the first area to a sum of an area of the first conductive contact layers and an area of the second conductive contact layers is greater than or equal to 0.1% and less than or equal to 5%.

10. The solar cell according to claim 1, wherein the at least one first conductive contact layer whose projection overlaps with the projection of the bus electrodes on the semiconductor substrate has a first area, first conductive contact layers that are each between two adjacent bus electrodes has a second area, and a ratio of the second area to the first area is greater than or equal to 5% and less than or equal to 20%.

11. The solar cell according to claim 1, wherein a ratio of a sum of areas of first conductive contact layers and second conductive contact layers that are formed on the first surface of the semiconductor substrate to an area of the first surface of the semiconductor substrate is greater than or equal to 5% and less than or equal to 15%; and/or
a ratio of a sum of areas of first conductive contact layers and second conductive contact layers that are formed on the second surface of the semiconductor substrate to an area of the second surface of the semiconductor substrate is greater than or equal to 5% and less than or equal to 15%.

12. A method for manufacturing a solar cell, comprising:
providing a semiconductor substrate, wherein the semiconductor substrate has a first surface and a second surface opposite to each other;
forming, on at least one of the first surface or the second surface of the semiconductor substrate, first conductive contact layers extending in a first direction and spaced apart in a second direction;
forming, on the first conductive contact layers, bus electrodes extending in the first direction and spaced apart in the second direction, wherein a projection of at least one of the first conductive contact layers on the semiconductor substrate overlaps with a projection of the bus electrodes on the semiconductor substrate, and the first direction is different from the second direction; and
forming collector electrodes extending in the second direction and spaced apart in the first direction, wherein at least one of the bus electrodes intersects with the collector electrodes.

13. The method for manufacturing a solar cell according to claim 12, comprising
forming, on at least one of the first surface or the second surface of the semiconductor substrate, second conductive contact layers extending in the second direction and spaced apart in the first direction, wherein
a projection of the collector electrodes on the semiconductor substrate overlaps with a projection of the second conductive contact layers on the semiconductor substrate; and at least one of the first conductive contact layers intersects with the second conductive contact layers.

14. The method for manufacturing a solar cell according to claim 12, wherein one or more first conductive contact layers are between two adjacent bus electrodes.

15. The method for manufacturing a solar cell according to claim 12, wherein a length of a first conductive contact layer between two adjacent bus electrodes is less than or equal to a length of a first conductive contact layer whose projection overlaps with the projection of the bus electrodes on the semiconductor substrate; and/or
a width of a first conductive contact layer between two adjacent bus electrodes is less than or equal to a width of a first conductive contact layer whose projection overlaps with the projection of the bus electrodes on the semiconductor substrate; and/or
a thickness of a first conductive contact layer between two adjacent bus electrodes is less than or equal to a thickness of a first conductive contact layer whose projection overlaps with the projection of the bus electrodes on the semiconductor substrate.
